## Europäisches Patentamt
## European Patent Office
## Office européen des brevets

(19)

(11) Publication number: **0 093 606**
**B1**

(12) # EUROPEAN PATENT SPECIFICATION

(45) Date of publication of the patent specification: 21.08.85

(51) Int. Cl.⁴: **G 01 R 19/165**

(21) Application number: **83302468.0**

(22) Date of filing: **29.04.83**

(54) Voltage level detecting circuitry.

(30) Priority: **30.04.82 JP 72912/82**

(43) Date of publication of application: **09.11.83 Bulletin 83/45**

(45) Publication of the grant of the patent: **21.08.85 Bulletin 85/34**

(84) Designated Contracting States: **DE FR GB**

(56) References cited:
**DE - A - 2 659 221**
**JP - A - 53 093 501**

**DER ELEKTRONIKER, Nr. 11, 1974, BISHIP, JONES "C-MOS, ein Bericht über den heutigen Stand", pages EI 11- EI 17**
**FRANZIS, DAS KLEINE PRAKTIKUM, Franzis-Verlag, 1977, München, PELKA "Schaltungen und Bausteine der Elektronik"**
**DER ELEKTRONIKER, Nr. 16, 1981, AUDERER "CMOS-Technologie - Basis für die Zukunft"**

(73) Proprietor: **FUJITSU LIMITED, 1015, Kamikodanaka Nakahara-ku, Kawasaki-shi Kanagawa 211 (JP)**

(72) Inventor: **Higuchi, Mitsuo, 5-13, Yutenji 2-chome, Meguro-ku Tokyo 153 (JP)**
Inventor: **Tsuchida, Manabu, 2-2-5, Edakita, Midori-ku, Yokohama-shi Kanagawa 227 (JP)**

(74) Representative: **Fane, Christopher Robin King et al, HASELTINE LAKE & CO. Hazlitt House 28 Southampton Buildings Chancery Lane, London, WC2A 1AT (GB)**

**0 093 606**

## Description

The present invention relates to voltage level detecting circuitry, for example to a voltage level detecting circuit for detecting whether the voltage supply applied to a semiconductor memory device is high or low.

In some semiconductor memory devices, for example, an erasable programmable read only memory device (EPROM), two voltage supplies are applied to the inner circuit, i.e., a usual fixed voltage supply $V_{CC}$ (5 V) and a variable voltage supply $V_{PP}$ changed to a high voltage level (21 V) when programming and to a low voltage level (5 V) when reading. In such a device, an inner detecting circuit usually detects whether the variable voltage supply is in the high or low voltage level. The output of the detecting circuit changes the operation of the memory device over to the programming or reading mode.

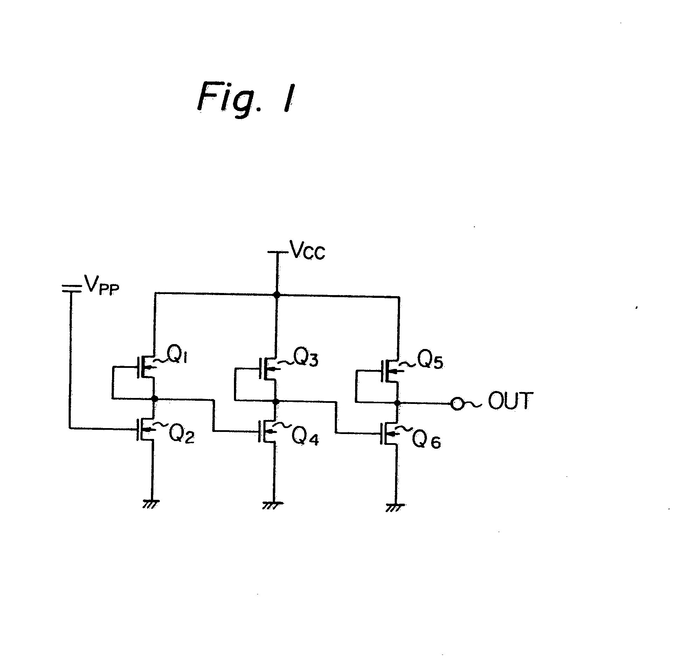

There is a known a prior art $V_{PP}$ level detecting circuit, Fig. 1, which comprises a first depletion type N-channel transistor, a first enhancement type N-channel transistor, a second depletion type N-channel transistor, a second enhancement type N-channel transistor, a third depletion type N-channel transistor, and a third enhancement type N-channel transistor. The first depletion type transistor and the first enhancement type transistor are connected in series between the fixed voltage supply $V_{CC}$. The gate of the first depletion type transistor is connected to its source, and the gate of the first enhancement type transistor is connected to the variable voltage supply $V_{PP}$. The second depletion type transistor and the second enhancement type transistor are connected in series between the fixed voltage supply and the ground. The gate of the second depletion type transistor is connected to its source, and the gate of the second enhancement type transistor is connected to the junction between the first depletion type transistor and the first enhancement type transistor. The third depletion type transistor and the third enhancement type transistor are connected in series between the fixed voltage supply $V_{CC}$ and the ground. The gate of the third depletion type transistor is connected to its source, and the gate of the third enhancement type transistor is connected to the junction between the second depletion type transistor and the second enhancement type transistor.

In this prior art detecting circuit, the conductivity gm of the first enhancement transistor is designed to be small so that when the variable voltage supply $V_{PP}$ is a low level (5 V) the first enhancement transistor cannot be turned on fully and so that when the variable voltage supply $V_{PP}$ is a high level (21 V), the first enhancement type transistor is fully turned on. Thus, the level of the junction between the first depletion type transistor and the first enhancement type transistor is a relatively »high« level when the variable voltage supply $V_{PP}$ is a low level (5 V). Thus, the second enhancement type transistor becomes on, the third enhancement type transistor becomes off, and, the output level becomes »high«. On the other hand, when the variable voltage supply $V_{PP}$ is a high level (21 V), the level of the junction between the first depletion type transistor and the first enhancement type transistor is a relatively »low« level. Thus, the second enhancement type transistor becomes off, the third enhancement type transistor becomes on, and the output level becomes »low«.

In the above-mentioned prior art voltage supply level detecting circuit, the ratio of the dimensions of the first depletion type transistor and the first enhancement type transistor are selected to a predetermined value. Therefore, the construction of the circuit is difficult, and it is difficult to achieve stable circuit operation.

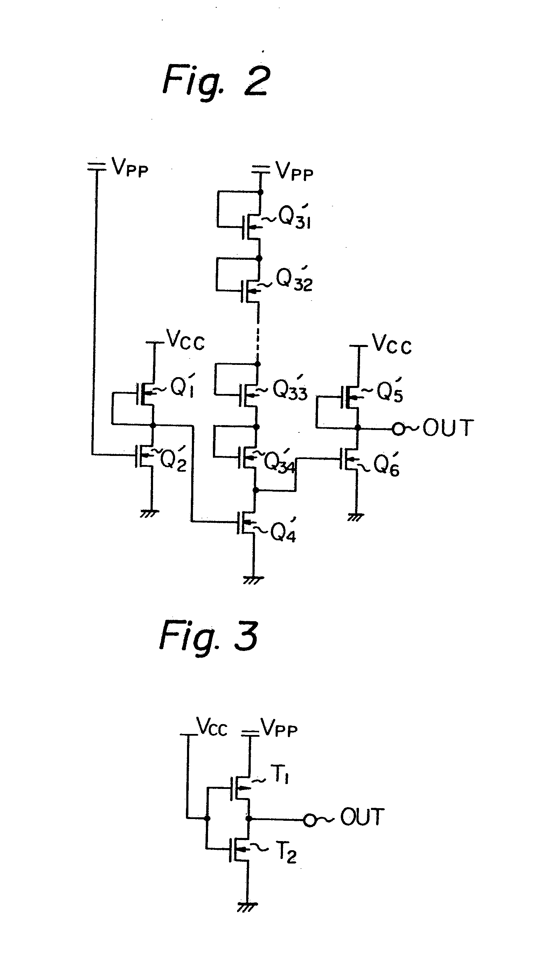

To counter these problems, there is proposed another prior art voltage supply level detecting circuit, Fig. 2, in which instead of the second depletion type transistor in the above-mentioned circuit, connected between the fixed voltage supply and the second enhancement type transistor, a group of enhancement type N-channel transistors, the gate of each connected to its drain, are connected in series between the variable voltage supply and the second enhancement type transistor.

In this circuit, the sum of the threshold values of the group of the enhancement type transistors is selected to be more than the low voltage supply level (5 V). When the variable voltage supply is a low level (5 V), the first enhancement type transistor is turned on, but nut fully, and the level of the junction between the first depletion type transistor and the first enhancement type transistor is relatively »high«, so that the second enhancement type transistor becomes on. Since the voltage across the group of series-connected enhancement type transistors is lower than 5 V, at least one of these transistors is off. Thus, the level of the drain of the second enhancement type transistor becomes low. Thus, the third enhancement type transistor becomes off and the output becomes a »high« level.

On the other hand, when the variable voltage supply $V_{PP}$ is a high level (21 V), the first enhancement type transistor is fully turned on, the level of its drain becomes a »low« level, and the second enhancement type transistor becomes off. Thus, the level of the drain of the second enhancement type transistor becomes a high level, which level is lower than the high level of $V_{PP}$ by the sum of the threshold voltages of the group of the series-connected enhancement type transistors. Thus, the third enhancement type transistor becomes on, and the output becomes a »low« level.

In this prior art detecting circuit, since the series-connected transistors become off when the variable voltage supply $V_{PP}$ is a low level, the second enhancement type transistor is not necessarily fully turned on. Accordingly, the required dimension ratio of the first depletion type transistor and the first enhancement type transistor is not so severe as the first mentioned prior art detecting circuit.

2

However, in the latter prior art detecting circuit, a number of series connected transistors are required in order to increase the sum of the threshold voltages of these transistors, and decrease the gate voltage of the third enhancement type transistor. Consequently, the number of components of this circuit can become undesirably large.

An embodiment of the present invention can provide a voltage supply level detecting circuit which has a small number of elements by using a complementary metal-insulator semiconductor (CMIS) circuit. This can produce a stable operation characteristic.

According to the present invention, there is provided voltage supply level detecting circuitry having first and second connection points to which first and second voltages respectively are applied, relative to a third connection point (ground), when the circuitry is in use, the said first voltage being held at a fixed level and the said second voltage being variable between a »high« voltage level and a »low« voltage level, and first and second MIS transistors of opposite respective conductivity types, having respective gates connected in common to the said first connection point, the load current path of the said first MIS transistor being connected between the said second connection point and a fourth connection point of the cicuitry, and the said second MIS transistor having its load current path connected between the said third and fourth connection points so as to be in series with the load current path of the first MIS transistor, whereby a »high«/»low« signal available at the said fourth connection point when the circuitry is in use can serve to provide an indication of whether the said second voltage is at its »high« voltage level or at its »low« voltage level.

Reference will now be made, by way of example, to the accompanying drawings, in which:

Figure 1 is a circuit diagram of a prior voltage supply level detecting circuit;

Figure 2 is a circuit diagram of another prior voltage supply level detecting circuit;

Figure 3 is a circuit diagram of a voltage supply level detecting circuit in accordance with a first embodiment of the present invention;

Figure 4 is a circuit diagram of a voltage supply level detecting circuit in accordance with a second embodiment of the present invention;

Figure 5 is a circuit diagram of a voltage supply level detecting circuit in accordance with a third embodiment of the present invention; and

Figures 6 and 7 are circuit diagrams of an EPROM in which the voltage supply level detecting circuit of Fig. 5 can be applied.

Before describing the preferred embodiments, the foregoing prior art voltage supply level detecting circuits are described in accordance with the drawings.

Figure 1 is a circuit diagram of a prior voltage supply level detecting circuit. The circuit of Fig. 1 comprises N-channel MIS transistors $Q_1$ through $Q_6$. The transistors $Q_1$, $Q_3$, $Q_5$ are depletion type transistors, and the transistors $Q_2$, $Q_4$, $Q_6$ are enhancement type transistors. The transistors $Q_1$ and $Q_2$ are connected in series between the fixed voltage supply $V_{CC}$ and the ground. The gate of the transistor $Q_1$ is connected to its source, and the gate of the transistor $Q_2$ is connected to the variable voltage supply $V_{PP}$. The transistors $Q_3$ and $Q_4$ are connected in series between the fixed voltage supply $V_{CC}$ and the ground. The gate of the transistor $Q_3$ is connected to its source, and the gate of the transistor $Q_4$ is connected to the junction of the transistors $Q_1$ and $Q_2$. The transistors $Q_5$ and $Q_6$ are connected in series between the fixed voltage supply $V_{CC}$ and the ground. The gate of the transistor $Q_5$ is connected to its source, and the gate of the transistor $Q_6$ is connected to the junction of the transistors $Q_3$ and $Q_4$. In the voltage supply level detecting circuit of Fig. 1, when the variable voltage supply $V_{PP}$ is a low level (5 V), the output OUT becomes »high«. When the variable voltage supply $V_{PP}$ is a high level (21 V), the output OUT becomes »low«. However, as described above, it is difficult to construct the dimension ratio of the transistors $Q_1$ and $Q_2$ to a desired value.

Figure 2 is a circuit diagram of another prior voltage supply level detecting circuit. The voltage supply level detecting circuit of Fig. 2 comprises N-channel MIS transistors $Q_1'$, $Q_2'$, $Q_{31}'$, $Q_{32}'$, . . .,$Q_{33}'$, $Q_{34}'$, $Q_4'$, $Q_5'$ and $Q_6'$. The construction of the detecting circuit of Fig. 2 is the same as that of the detecting circuit of Fig. 1, execpt that a group of series connected enhancement type transistors are connected between the variable voltage supply $V_{PP}$ and the enhancement type transistor $Q_4'$. In the voltage supply level detecting circuit of Fig. 2, the sum of the threshold voltages of the transistors $Q_{31}'$, $Q_{32}'$, . . ., $Q_{33}'$ and $Q_{34}'$ is more than the low level (5 V) of the variable voltage supply $V_{PP}$. Thus, when the variable voltage supply $V_{PP}$ is a low level (5 V), at least one of these transistors $Q_{31}'$, $Q_{32}'$, . . ., $Q_{33}'$ and $Q_{34}'$ becomes off. Accordingly, even if the transistor $Q_4'$ is not fully turned on, the level of the gate of the transistor $Q_6'$ becomes »low« and the transistor $Q_6'$ becomes off. Thus, the output OUT becomes a »high« level. When the variable voltage supply $V_{PP}$ is a high level (21 V), the transistor $Q_2'$ becomes fully on, the gate voltage of the transistor $Q_4'$ becomes »low« level, and the transistor $Q_4'$ becomes off. Accordingly, the gate voltage of the transistor $Q_6'$ becomes a »high« level (lower than the level of $V_{PP}$ by the sum of the threshold voltages of the transistors $Q_{31}'$, . . ., $Q_{33}'$ and $Q_{34}'$), the transistor $Q_6'$ becomes on, and the output OUT becomes a »low« level. In the voltage supply level detecting circuit of Fig. 2, the number of required elements becomes large. The circuit of Fig. 2 is disclosed in Japanese Patent Application No. 53-93 501 (1978).

A voltage supply level detecting circuit in accordance with a first embodiment of the present invention is illustrated in Fig. 3. The voltage supply level detecting circuit of Fig. 3 is an embodiment of

0 093 606

the present invention and comprises enhancement type MIS transistors $T_1$ and $T_2$. The transistor $T_1$ is a P-channel and the transistor T2 is a N-channel. The transistor $T_1$ and $T_2$ are connected in series between the variable voltage supply $V_{PP}$ and the ground. The gates of the transistors $T_1$ and $T_2$ are both connected to the fixed voltage supply $V_{CC}$. The junction of the transistors $T_1$ and $T_2$ is connected to the output OUT. These transistors $T_1$ and $T_2$ form a CMIS circuit.

When the variable voltage supply is a low level, that is, $V_{PP} = V_{CC} = 5$ V, the transistor $T_1$ becomes off because the gate-source voltage of the transistor $T_1$ is 0 V, and the transistor $T_2$ becomes on because the gate-source voltage of the transistor $T_2$ is more than the threshold voltage. Thus, the output OUT becomes off. When the variable voltage supply $V_{PP}$ is a high level, that is, $V_{PP} = 21$ V, the transistors $T_1$ and $T_2$ are both turned on, because the gate-source voltage of the transistor $T_1$, that is $(V_{PP} - V_{CC})$, becomes more than the threshold voltage $V_{THP}$ of the transistor $T_1$. In this case, the level of the output OUT is determined by the ratio of the conductance gm of the transistors $T_1$ and $T_2$. Thus, by selecting this ratio to a proper value, the output OUT becomes a »high« level. As described above, in accordance with the voltage supply level detecting circuit of Fig. 3, it can be readily detected whether the variable voltage supply $V_{PP}$ is higher than $(V_{CC} + V_{THP})$ or not.

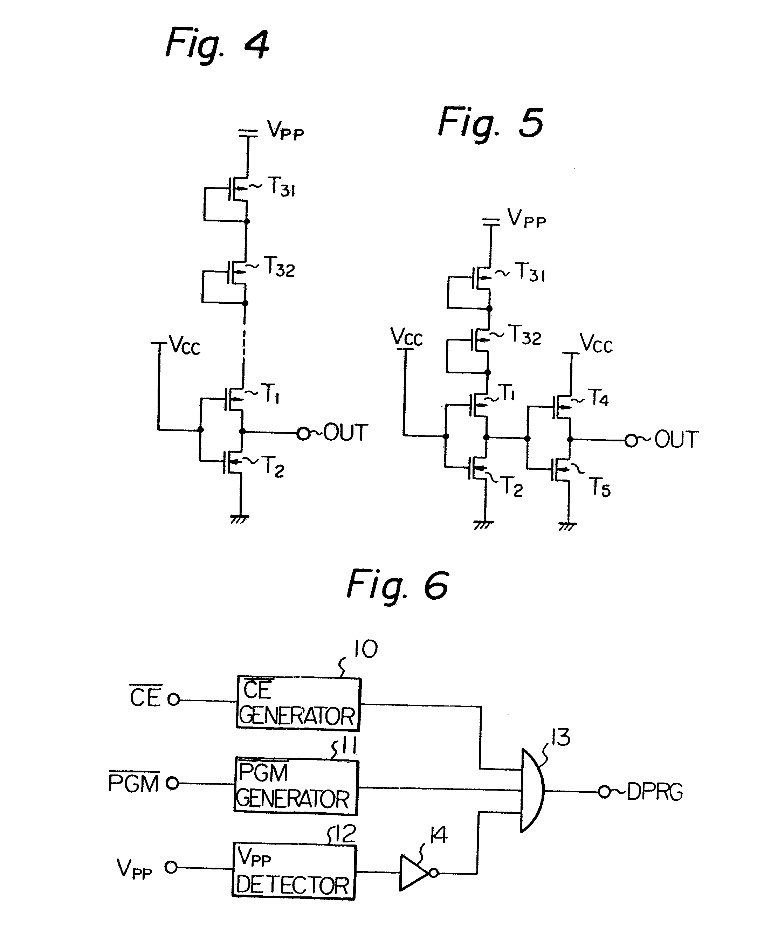

A voltage supply level detecting circuit in accordance with a second embodiment of the present invention is illustrated in Fig. 4. The voltage supply level detecting circuit of Fig. 4 comprises a P-channel transistor $T_1$, an N-channel transistor $T_2$, a plurality of P-channel transistors $T_{31}$, $T_{32}$, and so on. The construction of the voltage suply level detecting circuit of Fig. 4 is the same as that of the circuit of Fig. 3, except that the transistors $T_{31}$, $T_{32}$ ... are connected in series between the variable voltage supply $V_{PP}$ and the P-channel transistor $T_1$. The gate of each of these series-connected transistors $T_{31}$, $T_{32}$ ... is connected to its source. The number n of these series-connected transistors $T_{31}$, $T_{32}$ ... is selected in the range fulfilling the following condition:

$$V_{PP} \text{ (high level)} - n \cdot |V_{THP}| > V_{CC} + |V_{THP}|$$

In the voltage supply level detecting circuit of Fig. 4, when the variable voltage supply is a low level, that is, $V_{PP} = V_{CC} = 5$ V, the transistor $T_1$ becomes off, the transistor $T_2$ becomes on, and the output OUT becomes a »low« level. On the other hand, when the variable voltage supply $V_{PP}$ is a high level, that is, $V_{PP} = 21$ V, the transistors $T_1$ and $T_2$ become on and all of the transistors $T_{31}$, $T_{32}$ ... also become on. Thus, the output OUT becomes a »high« level. This »high« level is determined by the ratio of transistor conductance gm between the transistor $T_2$ and the other transistors $T_1$, $T_{31}$, $T_{32}$ ... In this case, the »high« level of the output OUT can be readily decreased to a proper level so that the output OUT can be connected directly to a gate of a next stage transistor with low breakdown voltage. For example, assuming that only two transistors $T_{31}$ and $T_{32}$ are inserted between the variable voltage supply $V_{PP}$ and the source of the transistor $T_1$ and that the conductances gm of all the transistors $T_1$, $T_2$, $T_{31}$ and $T_{32}$ are the same, the output OUT becomes 5.25 V ($= 21$ V/4).

Comparing the detecting circuit of Fig. 4 with the prior art detecting circuit of Fig. 2, the number of the series-connected transistors $T_{31}$, $T_{32}$ ... and $T_1$ required in Fig. 4 is less than the number of the series-connected transistors $Q_{31}'$, $Q_{32}'$, ..., $Q_{33}'$ and $Q_{34}'$, required in Fig. 2, since the source-drain voltage $V_{SD}$ is used in the circuit of Fig. 4 instead of the threshold voltage $V_{TH}$ to decrease the »high« level of the output to a proper level.

A voltage supply level detecting circuit in accordance with a third embodiment of the present invention is illustrated in Fig. 5. The voltage supply level detecting circuit of Fig. 5 comprises P-channel MIS transistors $T_1$, $T_{31}$ and $T_{32}$ and an N-channel MIS transistor $T_2$ as well as the circuit of Fig. 4. It further comprises a P-channel MIS transistor $T_4$ and an N-channel MIS transistor $T_5$. The transistors $T_4$ and $T_5$ are connected in series between the fixed voltage supply $V_{CC}$ and the ground. The gates of the transistors are both connected to the junction of the transistors $T_1$ and $T_2$. The junction of the transistors $T_4$ and $T_5$ is connected to the output terminal OUT. The transistors $T_4$ and $T_5$ construct a CMIS inverter circuit. Thus, in the voltage supply level detecting circuit of Fig. 5, when the variable voltage supply $V_{PP}$ is a low level (5 V), the output OUT becomes a »high« level. When the variable voltage supply $V_{PP}$ is a high level (21 V), the output OUT becomes a »low« level. The transistors $T_{31}$ and $T_{32}$ may be replaced by N-channel transistors.

The voltage supply level detecting circuit of Fig. 3 may be used in a EPROM. Generally, in an EPROM, various operation modes exist in the programming operation and in the reading operation. These operation modes may be changed by external control signals $\overline{CE}$, $\overline{OE}$ and $\overline{PGM}$ and by the level of the variable voltage supply $V_{PP}$. The relation between the selected operation mode and the condition of the external control signals is shown in the following table.

4

Table

| Operation modes | Control signals | | | |
| --- | --- | --- | --- | --- |
| | $\overline{CE}$ | $\overline{OE}$ | $\overline{PGM}$ | $V_{PP}$ |
| Reading operation | | | | |
| Read | »L« | »L« | »H« | Low (5 V) |
| Stand-by | »H« | — | — | Low (5 V) |
| Output disable | »L« | »H« | — | Low (5 V) |
| Programming operation | | | | |
| Program | »L« | — | »L« | High (21 V) |
| Verify | »L« | »L« | »H« | High (21 V) |
| Inhibit | »H« | — | — | High (21 V) |

Thus, it is necessary to detect whether the variable voltage supply $V_{PP}$ is a high level or low level in the EPROM. Especially, the program mode in the programming operation can be discriminated from the output disable mode in the reading operation by the level of the variable voltage supply $V_{PP}$.

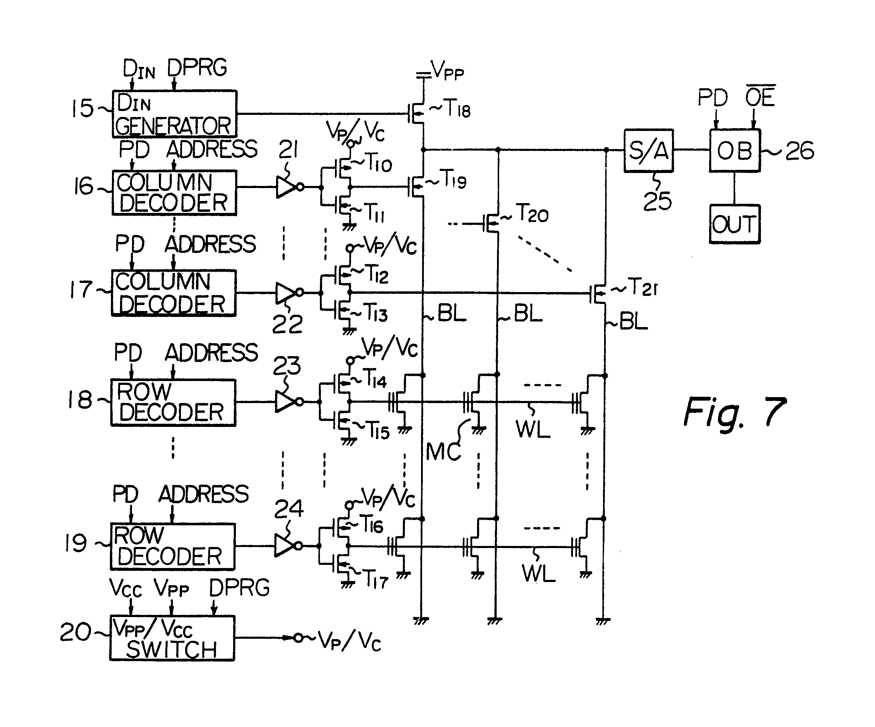

The circuit diagram of the EPROM is illustrated in Figs. 6 and 7. Figure 6 is a block diagram of a portion for generating an inner signal DPRG determining the program mode. In Fig. 6, 10 indicates a $\overline{CE}$ signal generator circuit, 11 indicates a $\overline{PGM}$ signal generator circuit, 12 indicates an $V_{PP}$ level detector circuit, 13 indicates an AND gate circuit, and 14 indicates an inverter circuit. Figure 7 is a circuit diagram of other portions of the EPROM. In Fig. 7, 15 indicates a data input ($D_{IN}$) signal generator circuit, 16 and 17 indicate column decoder circuits, 18 and 19 indicate row decoder circuits, 20 indicates a $V_{PP}/V_{CC}$ switch circuit, 21, 22, 23 and 24 indicate inverter circuits, 25 indicates a sense amplifier circuit, 26 indicates an output buffer circuit, $T_{10}$ through $T_{21}$ indicate transistors, WL indicates a word line, BL indicates a bit line, MC indicates a memory cell, OUT indicates an output terminal, PD indicates a power down signal, and $D_{IN}$ indicates a data input.

As seen from Fig. 6, the inner signal DPRG becomes a »high« level only when the signal $\overline{CE}$ is a »low« level, the signal $\overline{PGM}$ is a »low« level, and the variable voltage supply $V_{PP}$ is a high level (21 V). When the inner signal DPRG becomes a »high« level, the output $V_P/V_C$ of the $V_{PP}/V_{CC}$ switch circuit 20 becomes a high level (21 V) of the variable voltage supply $V_{PP}$, and the output $V_P/V_C$ is applied to the word line WL and the bit line BL through the transistors $T_{14}$, $T_{16}$, $T_{18}$, . . ., $T_{21}$. Thus, an electric charge is injected to the floating gate of the memory cell, and the data input $D_{IN}$ is written into the memory cell.

An embodiment of the present invention can provide a voltage supply level detecting circuit with a desirably simple structure which can detect whether the variable voltage supply is a high or low level.

**Claims**

1. Voltage level detecting circuitry having first and second connection points to which first and second voltages respectively are applied, relative to a third connection point (ground), when the circuitry is in use, said first voltage ($V_{CC}$) being held at a fixed level and said second voltage ($V_{PP}$) being variable between a »high« voltage level and a »low« voltage level, and first and second MIS transistors ($T_1$, $T_2$) of opposite respective conductivity types, having respective gates connected in common to said first connection point, the load current path of said first MIS transistor being connected between said second connection point and a fourth connection point (OUT) of the circuitry, and said second MIS transistor having its load current path connected between said third and fourth connection points so as to be in series with the load current path of the first MIS transistor, whereby a »high«/»low« signal available at said fourth connection point when the circuitry is in use can serve to provide an indication of whether the said second voltage is at its »high« voltage level or at its »low« voltage level.

2. Circuitry as claimed in claim 1, wherein the said first MIS transistor is connected to the said second connection point by way of at least one auxiliary MIS transistor ($T_{31}$) which has its load current path in series with that of the first MIS transistor and has its gate connected to its drain.

3. Circuitry as claimed in claim 1 or 2, further comprising third and fourth MIS transistors ($T_4$, $T_5$) of opposite respective conductivity types, having their load current paths connected in series between said first and third connection points and having their gates connected in common to said fourth connection point.

## Patentansprüche

1. Spannungspegeldetektorschaltung mit ersten und zweiten Anschlußpunkten, denen, relativ zu einem dritten Anschlußpunkt (Erde), eine erste bzw. eine zweite Spannung zugeführt wird, wenn die Schaltung im Betrieb ist, von denen die genannte erste Spannung ($V_{CC}$) auf einem festen Pegel gehalten wird und die genannte zweite Spannung ($V_{PP}$) zwischen einem »hohen« Spannungspegel und einem »niedrigen« Spannungspegel variabel ist, und mit ersten und zweiten MIS-Transistoren ($T_1$, $T_2$) von jeweils entgegengesetztem Leitfähigkeitstyp, deren jeweilige Gates gemeinsam mit dem genannten ersten Anschlußpunkt verbunden sind, wobei der Laststromweg des genannten ersten MIS-Transistors zwischen dem genannten zweiten Anschlußpunkt und einem vierten Anschlußpunkt (OUT) der Schaltung verbunden ist, und der Laststromweg des genannten zweiten MIS-Transistors zwischen dem dritten und dem vierten Anschlußpunkt so verbunden ist, daß er in Reihe mit dem Laststromweg des ersten MIS-Transistors liegt, wodurch ein »hohes«/»niedriges«-Signal, welches im Betrieb der Schaltung an dem vierten Anschlußpunkt verfügbar ist, dazu dienen kann, eine Anzeige zu liefern, ob die genannte zweite Spannung auf ihrem »hohen« Spannungspegel oder ihren »niedrigen« Spannungspegel ist.

2. Schaltung nach Anspruch 1, in welcher der genannte erste MIS-Transistor mit dem genannten zweiten Anschlußpunkt mittels wenigstens eines Hilfs-MIS-Transistors ($T_{31}$) verbunden ist, dessen Laststromweg in Reihe mit demjenigen des ersten MIS-Transistors liegt und dessen Gate mit seinem Drain verbunden ist.

3. Schaltung nach Anspruch 1 oder 2, ferner mit dritten und vierten MIS-Transistoren ($T_4$, $T_5$) von jeweils entgegengesetztem Leitfähigkeitstyp, deren Laststromwege in Reihe zwischen den ersten und dritten Anschlußpunkten und deren Gates gemeinsam mit dem genannten vierten Anschlußpunkt verbunden sind.

## Revendications

1. Circuit de détection de niveau de tension possédant un premier et un deuxième points de connexion auxquels sont respetivement appliquées une première et une deuxième tension, relativement à un troisième point de connexion (la terre), lorsque le circuit est utilisé, ladite première tension ($V_{CC}$) étant maintenue à un niveau fixe et ladite deuxième tension ($V_{PP}$) étant variable entre un niveau de tension »haut« et un niveau de tension »bas«, et un premier et un deuxième transistors MIS ($T_1$, $T_2$) de types respectivement opposés de conductivité, dont les grilles respectives sont connectées en commun sur ledit premier point de connexion, le trajet de courant de charge dudit premier transistor MIS étant connecté entre ledit deuxième point de connexion et un quatrième point de connexion (OUT) du circuit, et le trajet de courant de charge dudit deuxième transistor MIS étant connecté entre lesdits troisième et quatrième points de connexion de façon à se trouver en série avec le trajet de courant de charge du premier transistor MIS, si bien qu'un signal »haut«/»bas« disponible sur ledit quatrième point de connexion lorsque le circuit est utilisé peut servir à donner une indication du fait que ladite deuxième tension se trouve à son niveau de tension »haut« ou à son niveau de tension »bas«.

2. Circuit selon la revendication 1, où ledit premier circuit MIS est connecté audit deuxième point de connexion par l'intermédiaire d'au moins un transistor MIS auxiliaire ($T_{31}$) dont le trajet de courant de charge est en série avec celui du premier transistor MIS et dont la grille est connectée au drain.

3. Circuit selon la revendication 1 ou 2, comprenant en outre un troisième et un quatrième transistor MIS ($T_4$, $T_5$) de types respectifs de conductivité opposés, dont les trajets de courant de charge sont connectés en série entre lesdits premier et troisième points de connexion et dont les grilles sont connectées en commun audit quatrième point de connexion.

# Fig. 1

# Fig. 2

# Fig. 3

# Fig. 4

# Fig. 5

# Fig. 6

Fig. 7